# EUROPÄISCHE PATENTANMELDUNG

(11) **EP 3 611 709 A1**
(43) Veröffentlichungstag der Anmeldung: **19.02.2020**
(21) Anmeldenummer: 18189134.2
(22) Anmeldetag: 15.08.2018
(51) Int. Cl.: G08G 1/01, G01C 21/34, G08G 1/0968, G08G 1/082

(54) **VERKEHRSFLUSSSIMULATOR**

(71) Anmelder: Bernet, Aurelius, 8006 Zürich (CH)
(72) Erfinder: Bernet, Aurelius, 8006 Zürich (CH)
(74) Vertreter: Frei Patent Attorneys

(57) **Zusammenfassung**

In einem Verfahren zur Verkehrsflusssimulation werden, ausgehend von
• einem Verkehrsnetz (10) als Graph aus Wegabschnitten (3) und Knoten (4),
• mit Startorten (1) und Zielorten (2);
zur Bestimmung der Belastung von Wegabschnitten (3) die folgenden Schritte durchgeführt:
• für jeden Startort (1) und für jeden der Verkehrsteilnehmer des Startorts (1):
∘ Bestimmen, zu jedem der Zielorte (2), jeweils eines zugeordneten Verkehrsteilnehmerbruchteiles, entsprechend einer Aufteilung des Verkehrsteilnehmers auf die Zielorte;
∘ Bestimmen, zu jedem der Zielorte (2), jeweils eines zugeordneten optimalen Wegs (6) vom Startort (1) zum Zielort (2);
∘ Bestimmen, zu jedem der Zielorte (2), und für jeden Wegabschnitt (3) des optimalen Wegs (6), eines Aufenthaltsanteils (5) des Verkehrsteilnehmers im Wegabschnitt (3) als Funktion des Verkehrsteilnehmerbruchteiles, der diesem Zielort (2) zugeordnet ist;

• für jeden der Wegabschnitte (3) des Verkehrsnetzes (10):
∘ Bestimmen der Belastung des Wegabschnitts (3) durch Summation der Aufenthaltsanteile (5) aller Verkehrsteilnehmer in diesem Wegabschnitt (3).

## Beschreibung

Die Erfindung bezieht sich auf das Gebiet der Simulation von Verkehrsflüssen und insbesondere auf ein Verfahren, ein Datenverarbeitungssystem und ein Computerprogramm zur Verkehrsflussimulation gemäss dem Oberbegriff der entsprechenden unabhängigen Patentansprüche.

Verkehrsflussanalysen können auf verschiedenen Größenordnungen stattfinden. Dazu bestehen verschiedene Verkehrsmodelle, die auf unterschiedlichen Ansätzen beruhen und auf verschiedene Größenordnungen von Verkehrssystemen angewendet werden. Im Folgenden werden diese herkömmlichen Verkehrsmodelle auf mikroskopischer, makroskopischer und mesoskopischer Ebene besprochen.

Allen herkömmlichen Verkehrsmodellen oder Verkehrssimulationen ist gemeinsam, dass sie für Aussagen auf Statistiken von Verkehrszählungen angewiesen sind. Die Resultate der herkömmlichen Verkehrssimulationen beziehen sich somit immer auf eine Vergangenheit.

Eine der Problematiken der herkömmlichen Verkehrssimulationen sind die Aufteilungen des Verkehrs an Strassenkreuzungen oder Strassengabelungen. Die Aufteilungen werden aufgrund von Annahmen getroffen. Zur Hilfe dieser Annahmen dienen Statistiken der Verkehrszählungen. Da sich Verkehrsnetzte ständig ändern, sei es durch die Veränderung einer Stadt oder die Veränderung durch Strassenbaustellen, hinken die Annahmen immer der Zeit hinterher. Werden herkömmliche Verkehrssimulationen auf grosse Verkehrsnetze angewendet, sind die Resultate immer verzerrt.

### Mikroskopische Ebene

In diesem Verkehrsmodell werden die Fahrzeuge einzeln betrachtet. Die einzelnen Fahrzeuge werden als Agenten modelliert, die ein bestimmtes Beschleunigungs-, Geschwindigkeit- und Bremsverhalten haben. Ein Agent in einem Softwaresystem besteht aus Gleichungen, welche das Verhalten eines einzelnen Individuums, in diesem Falle ein Verkehrsteilnehmer, wiedergeben. Bei diesen Modellen wird von agentenbasierten Verkehrsmodellen gesprochen.

Im Gegensatz zu anderen Arten der Verkehrsmodellierung besteht die agentenbasierte Modellierung aus vielen einzelnen Verkehrsteilnehmern, die als einzelne Einheiten Entscheidungs- oder Handlungsmöglichkeiten haben. Das Systemverhalten resultiert aus dem Verhalten der einzelnen Agenten.

Mit diesen Modellen lassen sich Aussagen treffen, zum Beispiel wie sich Staubildungen ergeben auf Grund von bestimmten Verhalten der Verkehrsteilnehmer. Diese Art der Verkehrsmodellierung kommt vor allem dann zur Anwendung, wenn der Fokus einer Fragestellung auf einem begrenzten Raum liegt.

### Makroskopische Ebene

In Analogie zu Modellen der Strömungslehre werden für Fahrzeugdichten oder Durchschnittsgeschwindigkeiten partielle Differentialgleichungen verwendet. Für diese Verkehrssimulationen werden Verkehrsmodelle mit Quellen und Senken aufgebaut. Quellen sind Orte, wo der Verkehr in das Verkehrsmodell eingespeist wird. Senken sind Orte im Verkehrsmodell, wo der Verkehr wieder aus dem Verkehrsmodell entnommen wird. Jede Quelle ist einer Senke zugeordnet. Die Verkehrszahlen welche für die Quellen und Senken, beziehungsweise der eingespeiste oder wieder entnommene Verkehr, beruhen auf Statistiken von Verkehrszählungen, also auf historischen Daten.

Die Basis eines hierfür verwendeten Verkehrsmodells besteht aus einem mathematischen Graphen, der aus Kanten und Knoten besteht. Die Quellen und Senken liegen auf Knoten. Um auf den Wegen von einer Quelle zu einer Senke, den Verkehrsfluss, Fahrzeugdichten oder Durchschnittsgeschwindigkeiten berechnen zu können, werden die partiellen Differentialgleichungen aus der Strömungslehre verwendet. Diese Berechnungen sind für lineare Gleichungen weitgehend erforscht, weisen aber für nicht lineare Gleichungen viele Lücken auf.

### Mesoskopische Ebene

Bei diesen Verkehrsflussmodellen kommen mikroskopische und makroskopische Modelle zum Einsatz. Die makroskopischen Modelle bilden den Verkehr nur in seiner Masse ab, einzelne Fahrer/Fahrzeug-Einheiten werden nicht betrachtet. Diese Modelle erlauben Aussagen über den Verkehrsfluss und die Verkehrsdichte. Die mikroskopischen Verkehrsflussmodelle erlauben die Betrachtung auf die einzelnen Fahrer/Fahrzeug-Einheiten und können Aussagen über den Verkehrszustand geben.

Anwendungsgebiete dieser Modelle sind zum Beispiel Aussagen über Staubildungen in großen Verkehrsnetzen wie dem Autobahnnetz. Die Aussagen lassen sich aber auch hier nur immer aufgrund von Statistiken des Verkehrsaufkommens treffen, also wiederum auf historischen Daten. Verkehrsanalysen aufbauend auf diesen herkömmlichen Verkehrsmodellen zeigen immer nur die Vergangenheit oder die unmittelbare Vergangenheit.

Es ist deshalb Aufgabe der Erfindung, ein Verfahren, ein Datenverarbeitungssystem und ein Computerprogramm zur Verkehrsflussimulation der eingangs genannten Art zu schaffen, welche Alternativen zu den oben beschriebenen Ansätzen bieten.

Diese Aufgabe lösen ein Verfahren, ein Datenverarbeitungssystem und ein Computerprogramm zur Verkehrsflussimulation mit den Merkmalen der entsprechenden unabhängigen Patentansprüche.

Das Verfahren zur Verkehrsflusssimulation zur Bestimmung einer Belastung von Wegabschnitten in einem Verkehrsnetz, ausgeführt auf einer digitalen Datenverarbeitungseinheit, geht aus von
- einem Verkehrsnetz als Graph aus Wegabschnitten (entsprechend Kanten des Graphen) und Knoten,
- wobei eine erste Menge von Knoten Startorte sind, und jedem Startort eine Startortanzahl von *N_Si* Verkehrsteilnehmern zugeordnet ist, und eine zweite Menge von Knoten Zielorte sind;

Dabei werden zur Bestimmung der Belastung von Wegabschnitten die folgenden Schritte durchgeführt:
- für jeden Startort und für jeden der *N_Si* Verkehrsteilnehmer des Startorts:
   ∘ Bestimmen, zu jedem der Zielorte, jeweils eines zugeordneten Verkehrsteilnehmerbruchteiles, entsprechend einer Aufteilung des Verkehrsteilnehmers auf die Zielorte;
   ∘ Bestimmen, zu jedem der Zielorte, jeweils eines zugeordneten optimalen Wegs vom Startort zum Zielort;
   ∘ Bestimmen, zu jedem der Zielorte, und für jeden Wegabschnitt des optimalen Wegs, eines Aufenthaltsanteils des Verkehrsteilnehmers im Wegabschnitt als Funktion des Verkehrsteilnehmerbruchteiles, der diesem Zielort zugeordnet ist;
- für jeden der Wegabschnitte des Verkehrsnetzes:
   ∘ Bestimmen der Belastung des Wegabschnitts durch Summation der Aufenthaltsanteile aller Verkehrsteilnehmer in diesem Wegabschnitt.

Es findet also zur Bestimmung der Aufenthaltsanteile in den Wegabschnitten eine Iteration über die Startorte, die Verkehrsteilnehmer und deren Bruchteile, sowie über die Zielorte und die Wegabschnitte statt. Die Bestimmung der Belastung summiert also die Aufenthaltsanteile von jedem der optimalen Wege von jedem der Startorte zu jedem der Zielorte.

Der optimale Weg kann gemäss an sich bekannten Verfahren nach Massgabe von vorgebbaren Optimierungskriterien bestimmt werden. Solche Kriterien sind bsw. kürzester Weg, kürzeste Fahrzeit, geringster Energieverbrauch, ... etc.

Es ist unbestimmt, zu welchem Zielort ein Verkehrsteilnehmer von seinem Startort fährt, weshalb im neuen Verfahren zur Verkehrssimulation eine Streuung angewendet wird. Jeder einzelne Verkehrsteilnehmer von einem Startort wird durch die Anzahl möglicher Zielorte geteilt und ein entsprechender Verkehrsteilnehmerbruchteil über die kürzesten Wege zu allen möglichen Zielorten gestreut.

Jeder Verkehrsteilnehmerbruchteil ist also einem Zielort zugeordnet, und ebenso ist jeder der optimalen Wege einem Zielort zugeordnet. Somit ist - über den Zielort - auch jedem optimalen Weg ein Verkehrsteilnehmerbruchteil zugeordnet.

Eine Gesamtzahl der Verkehrsteilnehmer der Startorte kann aus einer urbanen Statistik vorgegeben werden. Die aus dem Verfahren resultierenden Verkehrsströme werden also aus urbanen Statistiken generiert und nicht aus Verkehrsstatistiken! Urbane Statistiken repräsentieren beispielsweise Bevölkerungszahlen, Nutzflächen von Gebäuden für Wohnen, Einkaufsmöglichkeiten, Arbeitsplätze, kulturelle Einrichtungen etc.

Gemäss Ausführungsformen ist es der Fall, dass der einem bestimmten Zielort zugeordnete Verkehrsteilnehmerbruchteil jeweils gleich einem diesem Zielort zugeordneten Zielgewichtungsfaktor, dividiert durch die Anzahl der Zielorte, ist.

In einer Ausführungsform ist der Verkehrsteilnehmerbruchteil jeweils gleich einem dem Zielort zugeordneten Zielgewichtungsfaktor, dividiert durch die Anzahl der Zielorte.

Gemäss Ausführungsformen ist es der Fall, dass der Verkehrsteilnehmerbruchteil jeweils gleich eins dividiert durch die Anzahl der Zielorte ist.

Beispielsweise ist der Zielgewichtungsfaktor eins, d.h. alle Ziele werden als gleich wichtig betrachtet. In dieser Ausführungsform ist der Verkehrsteilnehmerbruchteil jeweils gleich eins dividiert durch die Anzahl der Zielorte.

Gemäss Ausführungsformen ist es der Fall, dass der Aufenthaltsanteil des Verkehrsteilnehmers im Wegabschnitt als Funktion des Verkehrsteilnehmerbruchteiles bestimmt wird, indem der Aufenthaltsanteil als Funktion des Verkehrsteilnehmerbruchteils und einer Abschnittslänge des Wegabschnitts bestimmt wird.

Gemäss Ausführungsformen wird der Aufenthaltsanteil des Verkehrsteilnehmers im Wegabschnitt als Funktion des Verkehrsteilnehmerbruchteiles bestimmt, indem der Aufenthaltsanteil als Funktion des Verkehrsteilnehmerbruchteils und einer Abschnittslänge des Wegabschnitts bestimmt wird.

Gemäss Ausführungsformen ist es der Fall, dass der Aufenthaltsanteil des Verkehrsteilnehmers im Wegabschnitt als Produkt des Verkehrsteilnehmerbruchteils und der Abschnittslänge, dividiert durch die Länge des zugeordneten optimalen Wegs, bestimmt wird.

Gemäss Ausführungsformen wird der Aufenthaltsanteil des Verkehrsteilnehmers im Wegabschnitt als Funktion des Verkehrsteilnehmerbruchteiles bestimmt, indem der Aufenthaltsanteil gleich dem Verkehrsteilnehmerbruchteil gesetzt wird. Dies entspricht einer Situation, in welcher alle Abschnittslängen als gleich lang betrachtet werden.

Gemäss Ausführungsformen ist es der Fall, dass jeweils beim Bestimmen eines optimalen Wegs eine bereits vorhandene Belastung der Wegabschnitte berücksichtigt wird, insbesondere indem in jedem Wegabschnitt diese Belastung mit einer Abschnittskapazität des Wegabschnitts verglichen wird.

Dazu kann so vorgegangen werden, dass bei der Iteration über die die Startorte, die Verkehrsteilnehmer und deren Bruchteile, sowie über die Zielorte und die Wegabschnitte - jeweils während der Iteration - die Aufenthaltsanteile in den Wegabschnitten laufend aufsummiert werden. Wenn in einem der Wegabschnitte die Summe der Aufenthaltsanteile im Verhältnis zur Abschnittskapazität zu gross wird, wird dies bei weiteren Iterationen bei der Bestimmung der jeweiligen optimalen Wege berücksichtigt.

Gemäss Ausführungsformen ist es der Fall, dass die folgenden Schritte für eine Kalibrierung der Simulation durchgeführt werden:
- Messen mindestens eines realen Verkehrsflusses, wobei jeder reale Verkehrsfluss einem realen Messungs-Wegabschnitt zugeordnet ist und in diesem gemessen wird;
- Berechnen eines Kalibrierungsfaktors anhand des mindestens einen realen Verkehrsflusses und der in der Simulation bestimmten Belastung respektive Belastungen der Wegabschnitte, welche den realen Messungs-Wegabschnitten entsprechen;
- Berechnen einer kalibrierten Belastung der übrigen Wegabschnitte nach Massgabe des Kalibrierungsfakores.

Dieses Vorgehen erlaubt es, eine kleinere Anzahl von Verkehrsteilnehmern in der Verkehrsflusssimulation einzusetzen, als in der Realität auftreten werden. Bei der Simulation von grossen Städten mit vielen Verkehrsteilnehmern reduziert sich dadurch der Rechenaufwand. Die Kalibrierung kann im einfachsten Fall durch Multiplikation der Belastungen der Wegabschnitte (welche ja jeweils eine Summe von Aufenthaltsanteilen von Verkehrsteilnehmern sind) mit dem Kalibrierungsfaktor geschehen.

Gemäss Ausführungsformen ist es der Fall, dass
- bei der Iteration für jeden Startort und für jeden der N_Si Verkehrsteilnehmer des Startorts jeweils eine Startzeit vorgebbar ist;
- daraus jeweils eine Zeitinformation bestimmt wird, welche jedem der Aufenthaltsanteile des Verkehrsteilnehmers in den Wegabschnitten zugeordnet ist; und
- die Summation der Aufenthaltsanteile aller Verkehrsteilnehmer in einem Wegabschnitt unter Berücksichtigung der jeweiligen Zeitinformationen geschieht.

Die Zeitinformation kann beispielsweise ein Zeitpunkt oder ein Zeitintervall sein, zu resp. in welchem der Aufenthaltsanteil des Verkehrsteilnehmers im Wegabschnitt vorliegt. Die Summation der Aufenthaltsanteile unter Berücksichtigung der jeweiligen Zeitinformationen kann beispielsweise die Aufenthaltsanteile jeweils für unterschiedliche Zeitintervalle einzeln summieren. Damit ist eine Verteilung der Aufenthaltsanteile über die Zeit ermittelbar.

In Ausführungsformen ist die Zeitinformation für alle Aufenthaltsanteile eines Verkehrsteilnehmers dieselbe. Das bedeutet, dass in einer Simulation eines zeitlichen Ablaufs alle Aufenthaltsanteile eines Verkehrsteilnehmers gleichzeitig, also zum selben Zeitpunkt einer Simulationszeit, im Netz erscheinen.

Dies ist im Gegensatz zu herkömmlichen, z.B. agentenbasierten Verfahren, in welchen der Weg eines Verkehrsteilnehmers im Netz über die Zeit nachgebildet wird, also der Standort des Verkehrsteilnehmers sich mit der (simulierten) Zeit respektive Simulationszeit ändert, indem er sich durch das Netz bewegt.

Die Berücksichtigung der jeweiligen Zeitinformationen kann dadurch geschehen, dass Aufenthaltsanteile eines Verkehrsteilnehmers nach Ablauf einer bestimmten Verweilzeit zu der Summation der Aufenthaltsanteile nicht mehr beitragen.

Sie kann auch dadurch geschehen, dass sie bei zunehmender Verweilzeit - von der Startzeit aus betrachtet - entsprechend einem vorgegebenen Verlauf in Funktion der Verweilzeit zu der Summation der Aufenthaltsanteile beitragen. Die Funktion kann stetig sein oder Sprünge aufweisen. Beispielsweise kann der Beitrag zur der Summation mit Null beginnen, mit zunehmender Verweilzeit bis zum Wert des Aufenthaltsanteils zunehmen, und dann wieder auf Null abnehmen. Oder der Beitrag kann mit dem Wert des Aufenthaltsanteils beginnen und mit zunehmender Verweilzeit auf Null abnehmen. Auch hier gilt: In allen Fällen kann die zeitliche Variation eines Aufenthaltsanteils gleichzeitig für alle Aufenthaltsanteile eines Verkehrsteilnehmers geschehen.

In entsprechenden Ausführungsformen ist ein zeitlicher Verlauf einer Variation eines Beitrags der Aufenthaltsanteile eines Verkehrsteilnehmers bei der Summation der Aufenthaltsanteile in den Wegabschnitten derselbe.

Indem die Beiträge der einzelnen Verkehrsteilnehmer im Verlauf der Simulationszeit jeweils zu unterschiedlichen Zeiten vorliegen, ergibt sich ein (simulierter) Verlauf der gesamten Belastung der Wegabschnitte über die Zeit, typischerweise über einen Tag. Die Qualtität und Aussagekraft dieser Belastungen respektive ihres zeitlichen Verlaufes ist hoch, obschon die verteilten Beiträge eines einzelnen Verkehrsteilnehmers, d.h. seiner Verkehrsteilnehmerbruchteile, in allen Wegabschnitten gleichzeitig beitragen respektive nicht beitragen.

Es wird also - im Gegensatz zu einem agentenbasierten System - keine Fahrt eines Verkehrsteilnehmers durch das Netz simuliert, wobei der Verkehrsteilnehmer zu verschiedenen Zeiten in verschiedenen Wegabschnitten befindet, sonderen während einer bestimmten Zeitdauer liegen alle Verkehrsteilnehmerbruchteile des Verkehrsteilnehmers in allen betroffenen Wegabschnitten der optimalen Wege zu allen Zielorten vor (und werden summiert), und ausserhalb dieser Zeitdauer liegen sie nicht vor.

Der simulierte Verlauf geht jeweils von einer aktuellen Topologie des Verkehrsnetzes aus. Bestimmte Parameter, welche von der Topologie im wesentlichen unabhängig sind, können durch Abgleich von Simulationen mit Messungen, beispielsweise Verkehrsflussmessungen, mittels Optimierungsverfahren bestimmt werden. Somit kann mit dem hier gezeigten Verfahren zur Verkehrsflusssimulation eine prädiktive, also zukunftsgerichtete Simulation der Verkehrsflüsse vorgenommen werden, für eine aktuelle Toplogie, welche von der Topologie abweicht, bei welcher die Messungen vorgenommen wurden. Dies ist ein wesentlicher Unterschied zur Verwendung von Messungen respektive historischen Daten für einen Tagesverlauf, da diese historischen Daten Änderungen in der Topologie nicht berücksichtigen können.

Ausgehend von der prädiktiven Simulation anhand der aktuellen Topologie kann über einen Tagesverlauf hinweg eine Steuerung von Verkehrsleitmitteln und/oder von einzelnen Verkehrsteilnehmern realisiert werden.

In Ausführungsformen weist das Verfahren die folgenden Schritte zur Bestimmung von Startzeiten der Verkehrsteilnehmer auf:
- Messen von zeitlichen Verläufen von realen Verkehrsflüssen, wobei jeder reale Verkehrsfluss einem realen Messungs-Wegabschnitt zugeordnet ist und in diesem gemessen wird;
- Durchführen eines Optimierungsverfahrens mit iterativ wiederholter Durchführung der Bestimmung der Belastung von Wegabschnitten, wobei die Startzeiten der Verkehrsteilnehmer variiert werden, um zeitliche Verläufe der Belastung von Wegabschnitten, welche den realen Messungs-Wegabschnitten entsprechen, den zeitlichen Verläufen der realen Verkehrsflüsse möglichst gut anzunähern.

Damit ist es möglich, den zeitlichen Verlauf der Startzeiten und damit die Variation der simulierten Belastungen im Verkehrsnetz der Realität anzunähern. Beispielsweise werden die Startzeiten respektive. deren zeitliche Verteilung, einmal, anhand der Messungen in einer bestimmten Topologie des Verkehrsnetzes, in der oben beschriebenen Weise bestimmt. Dann werden sie auch bei veränderter Topologie - beispielsweise durch Baustellen - bei der Verkehrsflusssimulation eingesetzt.

Gemäss Ausführungsformen geschieht eine Steuerung von Verkehrsleitmitteln, insbesondere Verkehrsampeln, nach Massgabe der Belastungen der Wegabschnitte. Dabei können beispielsweise Verkehrsflüsse aus relativ höher belasteten Wegabschnitten gegenüber weniger belasteten Wegabschnitten bevorzugt werden.

In Ausführungsformen weist das Verfahren die folgenden Schritte auf:
- Bestimmen mindestens einer belasteten Route als zusammenhängende Menge von in einer Bewegungsrichtung aufeinanderfolgenden Wegabschnitten, deren Belastung ein bestimmtes Mass überschreitet;
- Schalten, während einer vorgegebenen Grünintervallzeit, aller Ampeln in der belasteten Route auf Grün.

Dabei werden Wegabschnitte gemäss Bewegungsrichtung getrennt betrachtet. Das heisst, dass das Bestimmen, welche Wegabschnitte einer belasteten Route zugehören und/oder das Schalten der Ampeln, jeweils für die beiden Bewegungsrichtungen getrennt vorgenommen werden. Dies kann geschehen, indem Wegabschnitte entlang derselben Kante aber in entgegengesetzte Richtungen als separate Wegabschnitte modelliert werden und ihre Belastung separat modelliert wird.

Das Bestimmen von belasteten Routen kann zu verschiedenen Simulationszeiten im Verkehrsnetz wiederholt ausgeführt werden. Dadurch ergeben sich je nach simulierter Tageszeit unterschiedliche belastete Wegabschnitte. Dem entsprechend kann die Schaltung der Ampeln im Tagesverlauf variieren.

In Ausführungsformen besteht eine belastete Route aus einer Folge von Wegabschnitten die in Bewegungsrichtung aufeinander folgen. An einer Eingangsseite eines belasteten Wegabschnittes können zwei oder mehr belastete Wegabschnitte in diesen einmünden. An einer Ausgangsseite eines belasteten Wegabschnittes kann dieser sich in zwei oder mehr aufteilen.

In Ausführungsformen weist das Verfahren die folgenden Schritte auf:
- Empfangen eines Startortes und eines Zielortes eines realen Verkehrsteilnehmers;
- Bestimmen einer für diesen realen Verkehrsteilnehmer optimalen Route, unter Berücksichtigung von in der Zukunft liegenden Belastungen der Wegabschnitte des Verkehrsnetzes;
- Übermittlung von Navigationsanweisungen entsprechend dieser optimalen Route an diesen realen Verkehrsteilnehmer.

Damit wird es möglich, nicht nur eine Navigationshilfe anhand eines historischen oder aktuellen Zustandes des Verkehrsnetzes zu bieten, sondern anhand eines mittels der Verkehrsflussimulation ermittelten zukünftigen Zustandes.

Das Datenverarbeitungssystem zur Verkehrsflussimulation weist Speichermittel mit darin gespeicherten Computerprogrammcodemitteln auf, welche ein Computerprogramm beschreiben, und Datenverarbeitungsmittel zur Ausführung des Computerprogramms, wobei die Ausführung des Computerprogramms zur Durchführung des Verfahrens zur Verkehrsflussimulation führt.

Das Computerprogramm zur Verkehrsflussimulation ist in einen internen Speicher einer digitalen Datenverarbeitungseinheit ladbar und weist Computerprogrammcodemittel auf, welche, wenn sie in einer digitalen Datenverarbeitungseinheit ausgeführt werden, diese zur Ausführung des Verfahrens zur Verkehrsflussimulation bringen. In einer bevorzugten Ausführungsform der Erfindung weist ein Computerprogrammprodukt einen Datenträger, respektive ein computerlesbares Medium auf, auf welchem die Computerprogrammcodemittel gespeichert sind.

Weitere bevorzugte Ausführungsformen gehen aus den abhängigen Patentansprüchen hervor.

Im folgenden wird der Erfindungsgegenstand anhand von bevorzugten Ausführungsbeispielen, welche in den beiliegenden Zeichnungen dargestellt sind, näher erläutert. Es zeigen jeweils schematisch:
- Figuren 1-4: ein Verkehrsnetz und darauf abgebildete Elemente zur Erklärung des Verfahrens;
- Figuren 5-6: ein Verkehrsnetz in unterschiedlichen Zuständen; und
- Figur 7: eine zeitliche Verteilung von Startzeiten.

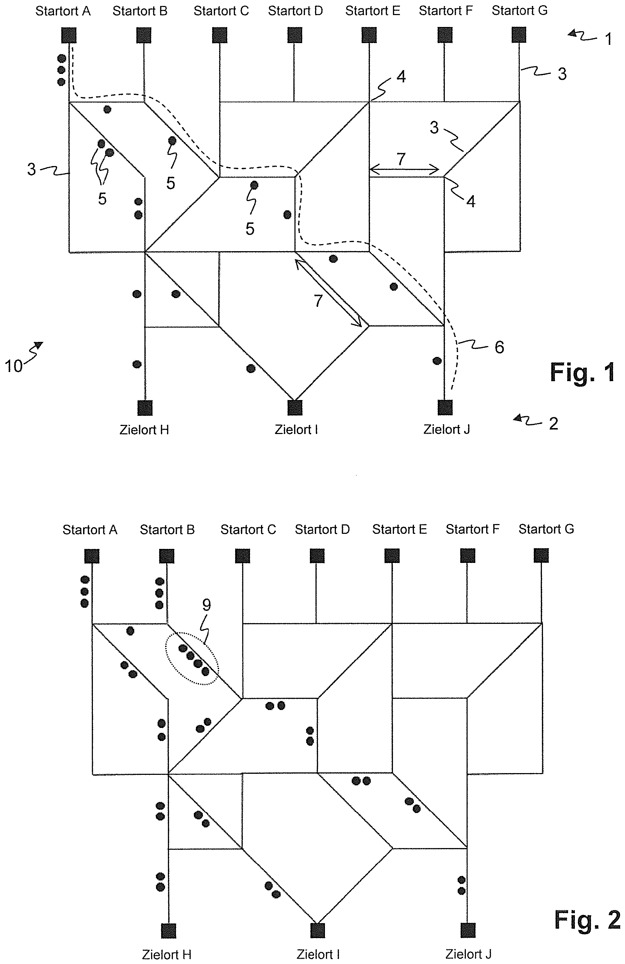

Im Verkehrsflusssimulator respektive im Verfahren zur Verkehrsflusssimulation werden die einzelnen Verkehrsteilnehmer in Verkehrsteilnehmerbruchteile geteilt und von ihrem Startort zu ihren Zielorten über das Verkehrsnetz verteilt oder gestreut. Die **Figur 1** zeigt die Teilung und Streuung eines Verkehrsteilnehmers. Die weiteren Bilder zeigen nacheinander die weiteren Teilungen und Streuungen weiterer Verkehrsteilnehmer. **Figur 1** zeigt ein Verkehrsnetz 10 mit Knoten 4 und Kanten, wobei Knoten Kreuzungen und die Kanten Wegabschnitten 3 entsprechen.

In der **Figur 1** wird als Beispiel ein Pendlerverkehr dargestellt, das heisst, der Verkehr von Wohnlokalitäten zu Arbeitsplätzen. Wohnlokalitäten (Startort A, B, C, D, E, F, G) werden in der weiteren Erklärung zusammenfassend als Startorte 1 benannt. Entsprechend werden die Arbeitsplätze (Zielorte H, J, I) in der weiteren Erklärung zusammenfassend als Zielorte 2 benannt.

Die Verkehrsteilnehmer eines ersten Startorts A werden entsprechend der Anzahl aller Zielorte 2 geteilt und vom ersten Startort A über optimale Wege 6, beispielsweise die kürzesten Wege zu den einzelnen Zielorten 2 gestreut. Die Gesamtzahl oder Startoranzahl der Verkehrsteilnehmer *N_Si* für jeden *i*-ten der Startorte 1 kann aus einer urbanen Statistik vorgegeben werden. Je nach Ziel der Simulation kann die Gesamtzahl gleich einer realen Anzahl von Verkehrsteilnehmern gesetzt werden, oder sie kann proportional zur realen gesetzt werden, mit dem gleichen Proportionalitätsfaktor für alle Startorte 1. Die Startortanzahl kann auch für jeden der Startorte 1 eins betragen, wenn allen Startorten 1 gleich viele Verkehrsteilnehmer zugeordnet sind.

Im aufgeführten Beispiel, in **Figur 1****,** wird ein einzelner Verkehrsteilnehmer durch die Anzahl Zielorte 2 geteilt. In diesem Beispiel durch drei, entsprechend der Anzahl Zielorte 2. Vom ersten Startort A wird jede Kante zum ersten Zielort H des Verkehrsnetzes mit einem Bruchteil des Verkehrsteilnehmers (Verkehrsteilnehmerbruchteil) markiert. Dasselbe Verfahren wird für den optimalen Wege 6, in diesem Fall dem kürzesten Weg vom ersten Startort A zum zweiten Zielort I durchgeführt. Das Verfahren wird, zur Vervollständigung ebenfalls für den kürzesten Weg vom ersten Startort A zum dritten Zielort J durchgeführt.

Im Beispiel in der **Figur 1** gibt es vom ersten Startort A drei optimale, in diesem Fall kürzeste Wege 6 zu den drei Zielorten 3. Ein Verkehrsteilnehmer des ersten Startorts A wird durch die Anzahl möglicher Zielorte 3 geteilt und über die drei optimalen Wege 6 zu den Zielorten 3 gestreut. Die Streuung ist in den Figuren durch runde Markierungen, entsprechend einem Aufenthaltsanteil 5 dargestellt. Dieser kann bei gleich langen Wegabschnitten 3 jeweils gleich einem Verkehrsteilnehmerbruchteil sein. Kanten resp Wegabschnitte 3 können auf mehren Wegen liegen, weshalb sie auch mehrmals markiert werden können. Die erste Kante vom Startort A aus liegt auf allen drei kürzesten Wegen zu den drei Zielorten, weshalb sie dreimal markiert wurde. Kanten, bei denen sich die Wege nicht überlagern, sind nur einmal markiert. Kanten, wo sich zwei Wege überlagern, sind zweimal markiert. Die Wege von den Startorten zu den Zielorten können sich überlagern. Kanten, die auf überlagerten Wegen liegen, werden mehrmals markiert. Gemäss der Bewegungsrichtung der Verkehrsteilnehmer werden die Aufenthaltsanteile 5 jeweils in Bewegungsrichtung rechts von den Kanten angezeigt. Wegabschnitte 3 entlang derselben Kante aber in entgegengesetzte Richtungen können als separate Wegabschnitte 3 betrachtet und ihre Belastung separat modelliert werden. In anderen Ausführungsformen werden die Belastungen von Wegabschnitten 3 auf derselbern Kante ungeachtet der Bewegungsrichtung betrachtet und summiert.

In der **Figur 2** wird das Verfahren der Streuung auf den zweiten Startort fortgesetzt. Wieder werden die Verkehrsteilnehmer des Startortes B entsprechend der Anzahl der Zielorte geteilt und über die kürzesten Wege vom Startort B zu allen Zielorten gestreut. Die Streuung 1 vom Startort A zu allen Zielorten und die Streuung 2 vom Startort B zu allen Zielorten überlagern sich auf Kanten die auf gemeinsamen Wegen liegen.

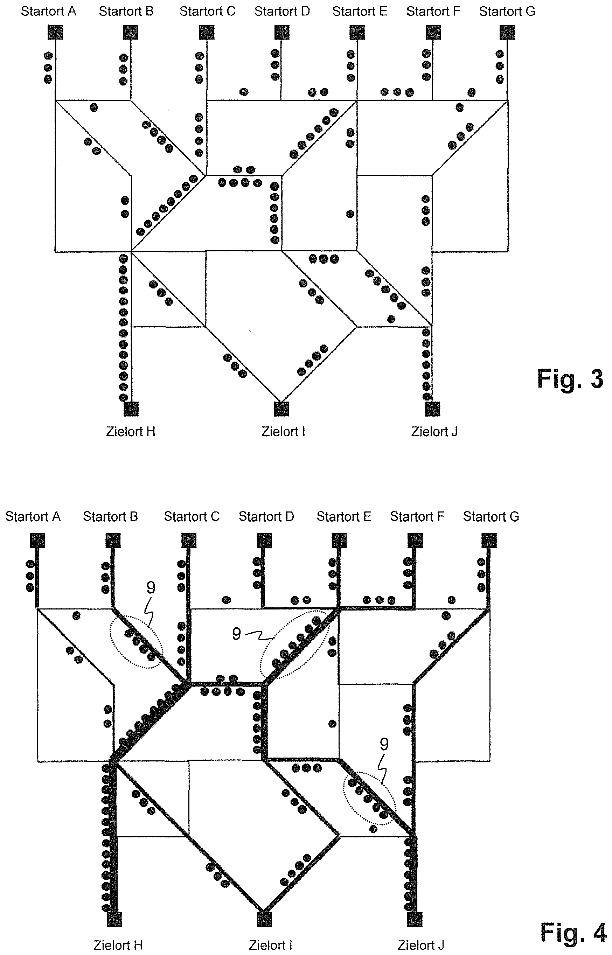

In **Figur 3** wird das Verfahren der Streuung auf alle weiteren Startorte fortgesetzt. Jeder einzelne Verkehrsteilnehmer der Startorte wird entsprechend der Anzahl der Zielorte geteilt und über die kürzesten Wege von den Startorten zu den Zielorten gestreut. Die Streuungen von allen Startorten zu allen Zielorten, und damit die Aufenthaltsanteile 5 überlagern sich auf den Kanten, die auf gemeinsamen Wegen liegen.

Ist das Verfahren der Streuung von jedem Startort zu jedem Zielort abgeschlossen, werden die Markierungen respektive Aufenthaltsanteile 5 auf den Kanten summiert. Diese Summen sind ein Mass für die Verkehrsdichten und, daraus abgeleitet, auch die Verkehrsflüsse der einzelnen Wegabschnitte 3 im Verkehrsnetz 10. Aus der Verkehrsdichte kann eine Geschwindigkeit der Verkehrsteilnehmer in den Wegabschnitten 3 berechnet werden. Dazu bestehen bekannte Verfahren. Sie gehen davon aus, dass sich Verkehrsteilnehmer mit einer sicheren Fahrweise ihre Geschwindigkeit der Dichte anpassen, unter Einhalten der örtlichen Maximalgeschwindigkeit. Aus der Verkehrsdichte und der Geschwindigkeit wiederum kann der Verkehrsfluss bestimmt werden.

Allgemein gilt, dass der Verkehrsfluss (Anzahl Fahrzeuge je Zeiteinheit) gleich dem Produkt von Geschwindigkeit (Strecke je Zeiteinheit) und Verkehrsdichte (Anzahl Fahrzeuge je Strecke) ist.

**Figur 3** zeigt beispielhaft den Verkehrszustand, d.h. die sich ergebenden Belastungen der Wegabschnitte, nachdem die Verkehrsteilnehmer respektive ihre Aufenthaltsanteile 5 für alle Startorte und Zielorte gestreut worden sind.

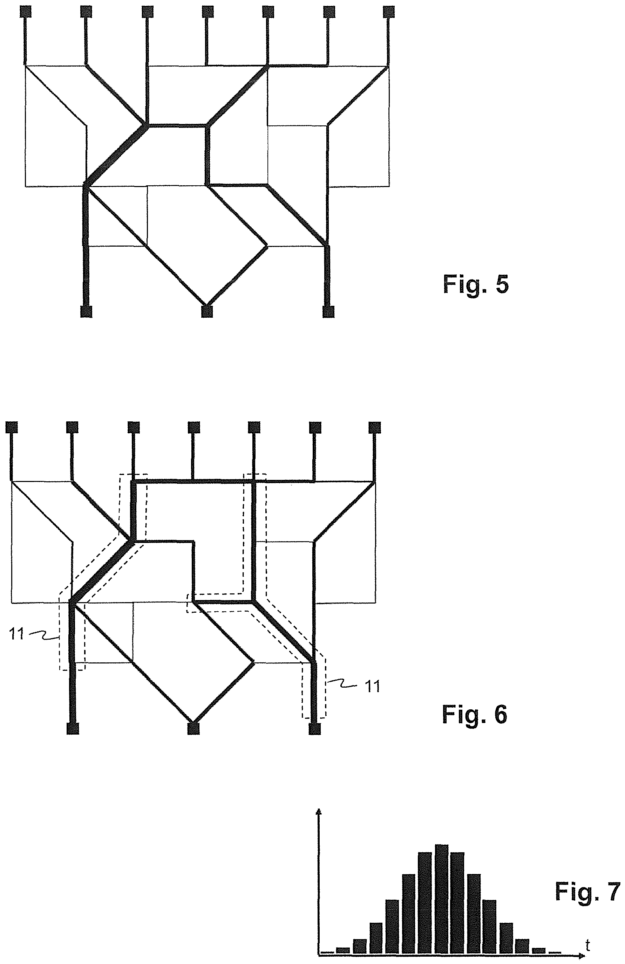

In **Figur 4** werden die Markierungen der Streuungen durch Strichstärken ersetzt, welche die Verkehrsdichten oder Verkehrsflüsse aus dem generierten Verkehr zeigen. **Figur 5** zeigt nur noch die Strichstärken, welche aus den Verkehrsdichten oder Verkehrsflüssen des erzeugten Verkehrs resultieren. In diesen Beispielen sind die Strichstärken vereinfacht und nicht gemäss der Bewegungsrichtung dargestellt. In anderen Ausführungsformen werden bei jeder Kante zwei Striche angezeigt, jeweils mit einer Stärke oder anderen grafischen Markierung entsprechend der Abschnittsdichte 9 in jeder den beiden Fahrtrichtungen respektive Wegabschnitten 3 entlang der Kante.

Die bisherige beispielhafte Beschreibung gilt für Verkehrsnetze mit gleichen Streckenabschnitten, oder Strecken gleicher Länge.

Für Verkehrsnetze mit unterschiedlichen Streckenabschnitten, beziehungsweise unterschiedlicher Kantenlängen, können die Markierungen proportional zu den Streckenabschnitten, beziehungsweise den Kantenlängen, vorgenommen werden. Das bedeutet, dass die Streuung auf einen einzelnen Streckenabschnitt proportional zur Weglänge von einem Startort zum Zielort erfolgt: je länger ein Streckenabschnitt ist, desto mehr Anteile eines Verkehrsteilnehmers erhält er, relativ zu den anderen Streckenabschnitten.

Sind im Verkehrssystem Zielorte eingebunden, welche eine unterschiedliche Attraktivität aufweisen, zum Beispiel beim Einkaufsverkehr unterschiedliche Einkaufsmöglichkeiten, so können die Teilung und die Streuung der einzelnen Verkehrsteilnehmer zur Anzahl der möglichen Zielorte eine Gewichtung erhalten, insbesondere eine relative Gewichtung, entsprechend der Attraktivität der Zielorte. Diese Gewichtung kann Zielgewichtungsfaktor genannt werden. Mehrere Zielgewichtungsfaktoren können jeweils als reelle, insbesondere ganzzahlige Werte den Zielorten zugoerdnet sein. Sie können auch skaliert oder normiert sein, beispielsweise durch Division durch die Summe aller Zielgewichtungsfaktoren des betrachteten Netzes.

Ändern sich im Ablauf des Verfahrens die Abschnittsdichten 9, kann dies bei der Bestimmung der optimalen Wege berücksichtigt werden. Auch kann berücksichtigt werden, wenn die Abschnittsdichte 9 in einem Wegabschnitt 3 bezüglich einer Abschnittskapazität 8 dieses Wegabschnitts 3 zu gross wird. Somit können sich entsprechend dem Zustand des Verkehrsnetzes andere optimale Wege 6 von einem Startort zu den Zielorten ergeben. Dann erfolgt die weitere Streuung auf den neuen optimalen Wegen 6. Um die Simulation unabhängig von der Reihenfolge zu machen, in welche die Startorte 1 abgearbeitet werden, kann die iterative Streuuung der Verkehrsteilnehmer der Startorte 1 die Reihe der Startorte 1 mehrmals durchlaufen, wobei bei jedem Durchlauf nur ein Teil der Verkehrsteilnehmer jedes Standortes gestreut wird.

### Abbildung von zeitlichen Verkehrsschwankungen

Die zeitlichen Schwankungen der Verkehrsbelastungen können ebenfalls abgebildet werden. Entsprechend dem Aufkommen des Verkehrs und wieder Abfallen des Verkehrs wird die Streuung proportional zum Verkehrsaufkommen verstärkt oder geschwächt. Das bedeutet, die Verkehrsteilnehmer aus einem Startort werden nicht alle gleichzeitig zur Streuung verwendet. Entsprechend einer zeitlichen Verteilung des Verkehrsaufkommens (Figur 7) wird die Anzahl der Verkehrsteilnehmer eines Startortes über die Zeit aufgeteilt. Proportional zur Verteilung des Verkehrsaufkommens werden die einzelnen Teile der Verkehrsteilnehmer eines Startortes ebenfalls zeitlich verteilt und zur Streuung verwendet.

Bei dieser zeitlichen Verteilung und Streuung kann jeder Verkehrsteilnehmer, respektive können seine Aufenthaltsanteile, über eine bestimmte Dauer einer Simulationszeit hinweg, in den Wegabschnitten vorliegen. Während dieser Dauer der (Simulations)Zeit tragen sie zur Summation der Aufenthaltsanteile bei, anschliessend wieder nicht. Sie können während dieser Dauer auch nur mit einer zeitlich variierenden Gewichtung beitragen.

Bezogen auf die Darstellung gemäss der **Figur 3** bedeutet dies, dass beim Durchlaufen der Simulationszeit die einzelnen Aufenthaltsanteile 5 erscheinen und wieder verschwinden.

Dabei kann auch die zeitliche Verteilung der Verkehrsteilnehmer über die jeweiligen optimalen Wege 6 und die Wegabschnitte 3 ermittelt werden, ausgehend von der erwähnten zeitlichen Verteilung von Startzeiten. Die Geschwindigkeit und der Verkehrsfluss in einem Wegabschnitt 3 wiederum können von der Abschnittsdichte 9 im Wegabschnitt 3 abhängen respektive durch bekannte Verfahren aus diesen ermittelt werden. Wie oben schon erwähnt, können sich bei zunehmenden Abschnittsdichten 9 in Bezug zu den Abschnittskapazitäten 8 die optimalen Wege 6 ändern.

Die genannte zeitliche Streuung der Verkehrsteilnehmer kann an eine gemessene zeitliche Verteilung des Verkehrsaufkommens angepasst werden. Beispielsweise wird von einer Gaussverteilung einer Dreiecksverteilung der Startzeiten in den Startorten ausgegangen. Es können bei allen Startorten die gleiche oder verschiedene zeitliche Verteilungen gewählt werden. In einem Optimierungsverfahren können Parameter dieser Verteilungen (beispielsweise Breite und Höhe der Verteilung) variiert werden, um die zeitliche Verteilung der Belastung in Wegabschnitten, zu denen Messungen aus der Realität vorliegen, möglichst gut an diese anzugleichen. Wenn die Messungen einen Verkehrsfluss (also Fahrzeuge je Zeiteinheit) darstellen, kann zum Angleich aus der Belastung ebenfalls der (simulierte) Verkehrsfluss berechnet werden, wie andernorts schon beschrieben.

### Anwendung der Verkehrsflusssimulation

Ein typisches Strassennetz einer Stadt weist viele Strassenbaustellen auf, welche den Verkehrsfluss laufend verändern. Im Durchschnitt sind es z.B. in Europäischen Städten eine Baustelle auf 300 bis 500 Einwohner. Das kann für eine Stadt mit 100'000 Einwohnern 200 bis 350 Baustellen ergeben. In der Summe bleibt die Anzahl der Strassenbaustellen etwa gleich, aber ihre Standorte ändern sich laufend.

Die Strassenbaustellen einer Stadt verändern wöchentlich, oft auch täglich, das Verkehrsnetz. Diese Veränderungen des Verkehrsnetzes haben einen grossen Einfluss auf die Verkehrsflüsse. Wöchentlich, oder fast täglich suchen die Verkehrsteilnehmer ihren optimalen Weg durch das Strassennetz. Zudem erfährt eine Stadt ein Wachstum an Bewohnern und Arbeitsplätzen, was ebenfalls das Verkehrsnetz und die Verkehrsbelastung laufend ändert.

Bei herkömmlichen Verkehrssimulation, in denen Statistiken der Verkehrszählungen verwendet werden, kann immer nur ein historisches Verkehrsverhalten analysiert werden. Die Ergebnisse hinken hinter der Realität her: Bis solche Analysen durchgeführt sind, hat sich das Verkehrsverhalten aufgrund des veränderten Strassennetzes bereits wieder verändert.

Mit dem hier beschriebenen Verfahren zur Verkehrssimulation oder Verkehrsanalyse kann der Verkehr für einen bestimmten Zustand des Verkehrsnetzes real abgebildet werden. Zudem wird der Verkehr nicht aus einer Verkehrsstatistik generiert, sondern aus der urbanen Statistik (Einwohnern, Arbeitsplätze, Nutzungen etc.). Wird ein Strassennetz verändert, so kann bereits in der Planungsphase das Verkehrsverhalten (Verkehrsdichten, Verkehrsflüsse, Geschwindigkeiten etc.) einer gesamten Stadt prädiktiv analysiert werden. Diese prädiktiven Analysen bilden die Grundlagen um den Strassenverkehr, zum Zeitpunkt, wenn die Strassenbaustellen eröffnet werden, optimal zu lenken.

Zur Erläuterung zeigen die **Figuren 5** und **6** ein Strassennetz (**Figur 5**) und dasselbe Strassennetz abgeändert (**Figur 6**). Wird ein Verkehrsnetz abgeändert, ergibt sich über das abgeänderte Verkehrsnetz eine andere Streuung der Verkehrsteilnehmer. Die Verkehrsdichten sowie Verkehrsflüsse oder Fahrgeschwindigkeiten können sehr schnell und effizient ermittelt werden.

Herkömmliche Verkehrssimulationen haben ein Problem zur Ermittlung der Aufteilung des Verkehrs an Strassenkreuzungen oder Strassengabelungen. Dies führt zu Ungenauigkeiten der Verkehrsdichten und Verkehrsflüsse. Durch das hier beschriebenen Verfahren zur Verkehrssimulation oder Verkehrsanalyse wird dieses Problem ganz einfach durch die Streuung gelöst.

### Anwendung zur Verkehrssteuerung

Eine mögliche Anwendung ist die Koordinierung von Lichtschaltzeiten der Ampeln. In den meisten Städten sind die Lichtschaltzeiten der Ampeln für längere Zeiten auf eine fixe Zeit eingestellt. Verkehrsnetze der Städte werden aber wöchentlich oder täglich durch Strassenbaustellen verändert. Damit der Verkehr verflüssigt werden kann, können die Lichtschaltzeiten der Ampeln entsprechend dem erwarteten Verkehrsfluss angepasst werden.

Beispielsweise können Ampeln an einer Kreuzung so eingestellt werden, dass Verkehrsteilnehmer aus einem Wegabschnitt 3 bevorzugt werden, für den das Verfahren eine hohe Abschnittsdichte 9 - relativ zu anderen Wegabschnitten 3, die in die Kreuzung münden - ermittelt hat.

In Ausführungsformen werden belastete Routen bestimmt und bei der Schaltung der Ampeln bevorzugt. Belastete Routen bestehen aus Wegabschnitte mit relativ hoher Belastung ("belastete Wegabschnitte"). Eine belastete Route weist jeweils eine Folge von solchen Wegabschnitten auf. Sie bilden einen gerichteten Graphen ohne Schleifen. Dabei kann sich die Route verzweigen, indem ein belasteter Wegabschnitt sich in zwei anschliessende belastete Wegabschnitte aufteilt, oder zwei belastete Wegabschnitte sich zu einem vereinen. Es können mehrere disjunkte belastete Routen in einem Verkehrsenetz vorliegen. In einem einfachen Fall weiste eine belastete Route nur eine Sequenz von aufeinanderfolgenden belasteten Wegabschniten auf, ohne Verzweigungen. In der **Figur 6** sind beispielhaft zwei belastete Routen 11 strichliert umrandet: links eine ohne, rechts eine mit Verzweigungen.

Zur Bestimmung von belasteten Routen kann beispielsweise von einem ersten Wegabschnitt mit maximaler Belastung ausgegangen werden. Dann kann von diesem aus - in Bewegungsrichtung - vorwärts und rückwärts nach angrenzenden Wegabschnitten (jeweils einer oder mehr) mit hoher Belastung gesucht werden, welche den ersten Wegabschnitt speisen oder von diesem gespeist werden. Dieser Schritt kann iterativ vorwärts und rückwärts wiederholt werden, bis die Belastungen der betrachteten Wegabschnitte unter ein bestimmtes Mass fallen.

Eine belastete Route kann durch die Schaltung der Ampeln bevorzugt werden, indem wiederholt während einer bestimmten Zeitdauer - beispielsweise eine, zwei, drei oder mehr Minuten - alle Ampeln in der betrachteten Bewegungsrichtung entlang der belasteten Route auf grün geschaltet werden. Bei grösseren Verkehrsnetzen und grösseren Abständen zwischen Ampeln kann generell auch die Zeitdauer grösser gewählt werden.

Da die Verkehrsnetze respektive deren Topologie sich auch wöchentlich oder täglich ändern, z.B. durch Strassenbaustellen, ändert sich entsprechend auch der Verkehrsfluss auf eine Kreuzung. Während den Stosszeiten kann sich der Verkehrsfluss an einer Kreuzung innerhalb von Minuten ändern. Um den Verkehr verflüssigen zu können, müssen alle Ampeln eines Verkehrsnetzes die Lichtschaltzeiten innerhalb weniger Minuten entsprechend dem Verkehrsfluss ändern. Zudem müssen alle Ampeln eines Verkehrsnetzes durch diese Dynamik genau aufeinander abgestimmt sein. Eine solche Anpassung und Abstimmung kann mit dem hier vorgestellten Verfahren zur Verkehrsflusssimulation mit besserer Qualität realisiert werden als mit herkömmlichen Systemen, da ersteres eine prädiktive und der aktuellen Netztopolgie angepassten, Simulation und Ermittlung der Belastungen realisiert. Letztere hingegen verfügen nur über
- historische Messdaten über einen ganzen Tagesverlauf, die aber auf einer nicht mehr aktuellen Netztopologie beruhen, oder über
- Echtzeit-Daten über den Verkehrsfluss, die aber keine Aussage über die Zukunft enthalten.

Durch das hier beschriebene Verfahren zur Verkehrsflusssimulation und Verkehrsanalyse kann das Verkehrsnetz, mit aktuellen und zukünftigen Verkehrsveränderungen, prädiktiv über frei wählbare Zeitintervalle im Voraus analysiert werden. Damit können die Lichtschaltzeiten von Ampeln bestimmt und zueinander koordiniert werden, oder andere Verkehrsleitsysteme angesteuert und zueinander koordiniert werden. Dadurch kann proaktiv und im Voraus auf das erwartete Verkehrsverhalten in verschiedenen und wechselnden Zuständen des Verkehrsnetzes und seiner Belastung reagiert und der Verkehr zur Verflüssigung möglichst optimal gelenkt werden.

## Patentansprüche

1. Verfahren zur Verkehrsflusssimulation zur Bestimmung einer Belastung von Wegabschnitten (3) in einem Verkehrsnetz (10), ausgeführt auf einer digitalen Datenverarbeitungseinheit, ausgehend von
• einem Verkehrsnetz (10) als Graph aus Wegabschnitten (3) und Knoten (4),
• wobei eine erste Menge von Knoten (4) Startorte (1) sind, und jedem Startort (1) eine Startortanzahl von Verkehrsteilnehmern zugeordnet ist, und eine zweite Menge von Knoten (4) Zielorte (2) sind;
wobei zur Bestimmung der Belastung von Wegabschnitten (3) die folgenden Schritte durchgeführt werden:
• für jeden Startort (1) und für jeden der Verkehrsteilnehmer des Startorts (1):
∘ Bestimmen, zu jedem der Zielorte (2), jeweils eines zugeordneten Verkehrsteilnehmerbruchteiles, entsprechend einer Aufteilung des Verkehrsteilnehmers auf die Zielorte;
∘ Bestimmen, zu jedem der Zielorte (2), jeweils eines zugeordneten optimalen Wegs (6) vom Startort (1) zum Zielort (2);
∘ Bestimmen, zu jedem der Zielorte (2), und für jeden Wegabschnitt (3) des optimalen Wegs (6), eines Aufenthaltsanteils (5) des Verkehrsteilnehmers im Wegabschnitt (3) als Funktion des Verkehrsteilnehmerbruchteiles, der diesem Zielort (2) zugeordnet ist;
• für jeden der Wegabschnitte (3) des Verkehrsnetzes (10):
∘ Bestimmen der Belastung des Wegabschnitts (3) durch Summation der Aufenthaltsanteile (5) aller Verkehrsteilnehmer in diesem Wegabschnitt (3).

2. Verfahren gemäss Anspruch 1, wobei der einem bestimmten Zielort (2) zugeordneter Verkehrsteilnehmerbruchteil jeweils gleich einem diesem Zielort (2) zugeordneten Zielgewichtungsfaktor (21), dividiert durch die Anzahl der Zielorte (2), ist.

3. Verfahren gemäss Anspruch 1, wobei der Verkehrsteilnehmerbruchteil jeweils gleich eins dividiert durch die Anzahl der Zielorte (2) ist.

4. Verfahren gemäss einem der vorangehenden Ansprüche, wobei der Aufenthaltsanteil (5) des Verkehrsteilnehmers im Wegabschnitt (3) als Funktion des Verkehrsteilnehmerbruchteiles bestimmt wird, indem der Aufenthaltsanteil (5) als Funktion des Verkehrsteilnehmerbruchteils und einer Abschnittslänge (7) des Wegabschnitts (3) bestimmt wird.

5. Verfahren gemäss Anspruch 4, wobei der Aufenthaltsanteil (5) des Verkehrsteilnehmers im Wegabschnitt (3) als Produkt des Verkehrsteilnehmerbruchteils und der Abschnittslänge (7), dividiert durch die Länge des zugeordneten optimalen Wegs (6), bestimmt wird.

6. Verfahren gemäss einem der vorangehenden Ansprüche, wobei jeweils beim Bestimmen eines optimalen Wegs (6) eine bereits vorhandene Belastung der Wegabschnitte (3) berücksichtigt wird, insbesondere indem in jedem Wegabschnitt (3) diese Belastung mit einer Abschnittskapazität (8) des Wegabschnitts (3) verglichen wird.

7. Verfahren gemäss einem der vorangehenden Ansprüche, aufweisend die folgenden Schritte zur Kalibrierung der Simulation:
• Messen mindestens eines realen Verkehrsflusses, wobei jeder reale Verkehrsfluss einem realen Messungs-Wegabschnitt zugeordnet ist und in diesem gemessen wird;
• Berechnen eines Kalibrierungsfaktors anhand des mindestens einen realen Verkehrsflusses und der in der Simulation bestimmten Belastung respektive Belastungen der Wegabschnitte (3), welche den realen Messungs-Wegabschnitten entsprechen;
• Berechnen einer kalibrierten Belastung der übrigen Wegabschnitte (3) nach Massgabe des Kalibrierungsfakores.

8. Verfahren gemäss einem der vorangehenden Ansprüche, wobei
• bei der Iteration für jeden Startort (1) und für jeden der Verkehrsteilnehmer des Startorts (1) jeweils eine Startzeit vorgebbar ist;
• daraus jeweils eine Zeitinformation bestimmt wird, welche jedem der Aufenthaltsanteile (5) des Verkehrsteilnehmers in den Wegabschnitten (3) zugeordnet ist; und
• die Summation der Aufenthaltsanteile (5) aller Verkehrsteilnehmer in einem Wegabschnitt (3) unter Berücksichtigung der jeweiligen Zeitinformationen geschieht.

9. Verfahren gemäss Anspruch 8, wobei die Zeitinformation für alle Aufenthaltsanteile (5) eines Verkehrsteilnehmers dieselbe ist, und insbesondere ein zeitlicher Verlauf einer Variation eines Beitrags der Aufenthaltsanteile (5) eines Verkehrsteilnehmers bei der Summation der Aufenthaltsanteile (5) in den Wegabschnitten (3) derselbe ist.

10. Verfahren gemäss einem der Ansprüche 8 oder 9, aufweisend die folgenden Schritte zur Bestimmung von Startzeiten der Verkehrsteilnehmer:
• Messen von zeitlichen Verläufen von realen Verkehrsflüssen, wobei jeder reale Verkehrsfluss einem realen Messungs-Wegabschnitt zugeordnet ist und in diesem gemessen wird;
• Durchführen eines Optimierungsverfahrens mit iterativ wiederholter Durchführung der Bestimmung der Belastung von Wegabschnitten (3), wobei die Startzeiten der Verkehrsteilnehmer variiert werden, um zeitliche Verläufe der Belastung von Wegabschnitten (3), welche den realen Messungs-Wegabschnitten entsprechen, den zeitlichen Verläufen der realen Verkehrsflüsse möglichst gut anzunähern.

11. Verfahren gemäss einem der vorangehenden Ansprüche, aufweisend den Schritt:
• Steuerung von Verkehrsleitmitteln, insbesondere Verkehrsampeln, nach Massgabe der Belastungen der Wegabschnitte (3).

12. Verfahren gemäss Anspruch 11, aufweisend die Schritte:
• Bestimmen mindestens einer belasteten Route als zusammenhängende Menge von in einer Bewegungsrichtung aufeinanderfolgenden Wegabschnitten (3), deren Belastung ein bestimmtes Mass überschreitet;
• Schalten, während einer vorgegebenen Grünintervallzeit, aller Ampeln in der belasteten Route auf Grün.

13. Verfahren gemäss einem der Ansprüche 8 bis 12, aufweisend die Schritte:
• Eingabe eines Startortes und eines Zielortes eines realen Verkehrsteilnehmers;
• Bestimmen einer für diesen realen Verkehrsteilnehmer optimalen Route, unter Berücksichtigung von in der Zukunft liegenden Belastungen der Wegabschnitte (3) des Verkehrsnetzes;
• Übermittlung von Navigationsanweisungen entsprechend dieser optimalen Route an diesen realen Verkehrsteilnehmer.

14. Datenverarbeitungssystem zur Verkehrsflussimulation, wobei das Datenverarbeitungssystem Mittel aufweist zur Durchführung des Verfahrens nach einem oder mehreren der Ansprüche 1 bis 13.

15. Computerprogramm zur Verkehrsflussimulation, welches auf einer Datenverarbeitungseinheit ladbar und ausführbar ist, und welches bei der Ausführung das Verfahren nach einem oder mehreren der Ansprüche 1 bis 13 ausführt.
